Europäisches Patentamt

European Patent Office

Office européen des brevets

(19)

(11) Publication number: **0 303 384**
**A2**

(12) **EUROPEAN PATENT APPLICATION**

(21) Application number: **88307130.0**

(22) Date of filing: **02.08.88**

(51) Int. Cl.⁴: **H01R 4/04 , H01R 9/09**

(30) Priority: **10.08.87 JP 199678/87**

(43) Date of publication of application:
**15.02.89 Bulletin 89/07**

(84) Designated Contracting States:
**DE FR GB IT**

(71) Applicant: **MINNESOTA MINING AND MANUFACTURING COMPANY**
**3M Center, P.O. Box 33427**
**St. Paul, Minnesota 55133-3427(US)**

(72) Inventor: **Tanaka, Kiyotaka**
**3M Sumitomo Ltd.**
**Tokyo 158(JP)**
Inventor: **Hirasawa, Yuji**
**3M Sumitomo Ltd.**
**Tokyo 158(JP)**
Inventor: **Emori, Kenji**
**3M Sumitomo Ltd.**
**Tokyo 158(JP)**
Inventor: **Tasaka, Yoshihiko**
**3M Sumitomo Ltd.**
**Tokyo 158(JP)**

(74) Representative: **Baillie, Iain Cameron et al**
**c/o Ladas & Parry Isartorplatz 5**
**D-8000 München 2(DE)**

(54) **Flexible connector tape.**

(57) A flexible connector comprising a thin metallic film circuit on a substrate and an anisotropic electrically conductive adhesive layer thereover, where said adhesive layer contains plastic particles having at least one metallic coating on the surface thereof.

EP 0 303 384 A2

# FLEXIBLE CONNECTOR TAPE

## Technical Field

The invention relates to a heat and humidity stable, heat-bondable flexible connector tape for connection between display panels and printed circuit boards. The invention further relates to a flexible connector tape which enables electrical-electronic parts to be directly loaded and connected to a circuit terminal with heat and pressure.

## Background of the Invention

Loading requirements for electronic circuit parts have advanced to the point where smaller parts must be loaded into more elaborate and intricate circuitry. For example, in the case of portable liquid-crystal televisions, electrical connections must be made between conductors that are 0.2 mm or less apart. Such connections cannot be made using conventional techniques (i.e., solder and mechanical connectors).

Recently, loading techniques have been developed to meet these loading requirements. One such technique uses a combination of a flexible printed circuit board (FPCB) and an anisotropic electrically conductive adhesive, an organic adhesive with electrically conductive particles dispersed therein. In order to improve processability on automated assembly lines, both temporary and permanent welding steps are necessary. This two-step process increases manufacturing and labor costs and production time. Further, forced bending of the FPCB, required in certain applications, may induce stress in the FPCB and cause cracking of the conductors due to flexibility limitations. Thus in such applications it may be be difficult to obtain stable electrical connections.

On the other hand, heat-sealable connectors have greater flexibility than FPCB's. Like the anisotropic electrically conductive adhesive described above, heat-sealable connectors can be used to connect smaller conductors.

Japanese Patent Publication Kokai (Laid-open) No. 84786/1983 discloses a circuit made of an organic binder which contains electrically conductive carbon. Due to its high conductor resistance and connection resistance, this circuit has low current capacity. The circuit is formed by screen printing; however, fine pitches (e.g.,about 0.2 mm) cannot be obtained using this technique.

EP 215953 discloses a connector in which the circuit portion is a metallic electrically conductive first and second film layer covered with an electrically conductive isotropic third film layer consisting of a carbon powder and a synthetic resin. The circuit portion is covered by an electrically conductive anisotropic adhesive consisting of carbon powder and synthetic resin. The connector has high contact resistance.

EP 134624 discloses a multiple connector tape consisting of electrically conductive stripes on an insulative backing. The stripes are covered with an adhesive band which may contain electrically conductive particles which lower conductor resistance and contact resistance.

Various known metallic materials have been used to form circuits, including gold, silver, copper, aluminum, nickel, palladium platinum, chromium, tungsten, tin, lead, etc.

Gold exhibits superior resistance to moisture and heat, but it is very expensive. Further, it is difficult to form gold circuits using etching techniques. Silver is low in anchor force and becomes brittle under humid and heated conditions. However, silver is not suitable for all electrical uses because when an electrical potential difference is applied to silver, it easily migrates. These metals can be etched, but special equipment is necessary for proper handling of the poisonous cyanide compounds used in the etching solution. Nickel, as compared with these metals, exhibits superior corrosion resistance and anchor force and is subject to etching. However, it has a high resistivity, and it is brittle and subject to cracking due to its inherent hardness. Additionally, in electrical applications where nickel is used for welding in the form of a flexible connector, cracks may form in the metallic film due to localized stress (load) or thermal expansion and contraction of the substrate at the time of welding.

Further, the function of metallic materials for circuits can be improved by using the foregoing metals in alloys or in a plurality of layers. Among these, laminated circuits of nickel/copper/nickel have an advantage that the low corrosion resistance of copper is compensated by nickel and the high resistance of nickel is compensated by copper. This laminated film is good in corrosion resistance and resistance characteristics under humid and heated conditions, and is also subject to etching, but it has a problem that cracks tend to form due to the presence of nickel.

Gold, silver, nickel, etc. have been used as electrically conductive particles in prior art anisotropic electrically conductive adhesive layers and have lower resistivity than carbon. These particles may pierce or injure the metallic film circuit when they are pressed into the circuit during application, which results in a reduction in circuit characteristics.

## Summary of the Invention

According to the present invention, there is provided a flexible connector comprising a circuit consisting of a thin metallic film on a substrate and an anisotropic electrically conductive adhesive layer on the circuit, wherein the anisotropic electrically conductive adhesive contains plastic particles having metallic coatings on their surfaces.

The thin metallic circuit can be made from electrically conductive metals (i.e., gold, silver,etc.). Characteristics required for these metals are adhesion force to substrate materials (anchor force), corrosion resistance, change in the conductor (surface) resistance under humid and heated conditions, etc. Among these metals, those which are less subject to oxidation and deterioration under humid and heated conditions are gold, silver, nickel, etc.

The circuits may be formed of films consisting of a single metal, an alloy of two or metals, or laminated films made of these metals and/or alloys. The circuit in a preferred embodiment is a three-layer laminated film comprising a layer of nickel or nickel alloy, a layer of copper or copper alloy, and a layer of nickel or nickel alloy. Connector tapes according to the invention which employ this three-layer film circuit exhibit superior conductor (surface) resistance to moisture and heat, adhesion force to substrate (anchor force), corrosion resistance, processability and economy.

With the flexible connector of the present invention, it is possible to carry out fine connection between conductors simply, surely and economically. Further, the flexible connector of the present invention can be applied as a connector for visible fluorescent display panels, plasma display panels, etc. which require a larger electrical current than liquid crystal panels. Consequently, the markedly expanded application range of the connector of the present invention has extremely great significance from an industrial or commercial point of view.

An object of the present invention is to provide a film-form flexible connector which overcomes all the conventional problems described above and shows excellent conduction characteristics even in humid and heated circumstances.

## Brief Explanation of the Drawing

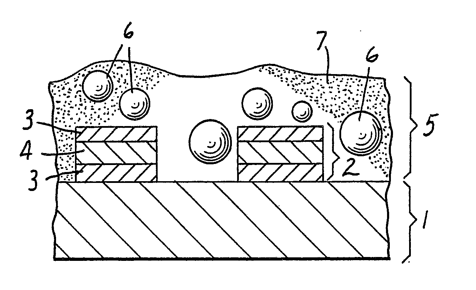

Figure 1 is a sectional view of one embodiment of the flexible connectors of the present invention.

## Detailed Description of the Invention

Figure 1 is a sectional view of a connector according to the invention. The connector is comprised of a substrate 1 with a circuit 2 comprised of a thin metallic film laminate thereon and an anisotropic electrically conductive adhesive layer 5. The circuit 2 consists of a thin metallic film laminate having a single copper layer 4 between two nickel layers 3. The anisotropic electrically conductive adhesive layer consists of an adhesive 7 with metal-covered plastic particles 6 dispersed therein.

Metallic materials which can be used in circuits of the present invention include gold, silver, platinum, copper, palladium, chromium, nickel, tungsten, tin, lead, etc. These metallic materials are formed into films made of these metals alone or an alloy consisting of two or more of them, and laminated films made of these metals or alloys. These metallic films can be formed into circuits by evaporation, sputtering, EB method, CVD method or ion-plating method. Of these films, three-layer laminated films comprising a layer made of nickel or an alloy containing 50% by weight or more of nickel, a layer made of copper or an alloy containing 50% by weight or more of copper and a layer made of nickel or an alloy containing 50% by weight or more of nickel are superior in conductor (surface) resistance to moisture and heating, anchor force, corrosion resistance, processability and economy.

The thickness of circuits made of thin metallic films is preferably $1\mu$ or less in order to maintain the bending resistance of the circuits and to prevent curling. In laminated circuits, when the topmost nickel layer of the circuit has pin holes, the intermediate or lowermost layer may corrode. In order to prevent such corrosion, the thickness of the topmost nickel layer is preferably 50 Angstrom ($\mathring{A}$) or more. For example, such laminated circuits could have the following constructions: topmost nickel layer (400 $\mathring{A}$)/intermediate copper layer (2000 $\mathring{A}$)/lowermost nickel layer (250 $\mathring{A}$) or topmost nickel layer (100 $\mathring{A}$)/lowermost copper layer (2000 $\mathring{A}$).

The choice of substrates affects the cracking resistance of the laminated films made of these metals. When a connector is welded to adherends, the welding portion experiences localized stress. The effect of this stress on the metallic circuit varies largely with the modulus of elasticity of the substrate. For example, when heat-welding is carried out at about 150°C using a connector in which the substrate is polyethylene terephthalate (PET) film, the welding temperature is higher than the glass transition temperature (Tg) of PET (70° to 80°C). The attendant expansion and contraction of the PET film caused by heat-welding affects the metallic circuit producing cracks. Conversely, with films having a high Tg (e.g., 280°C or higher) such as polyimide (PI) film, a change in the shape of the substrate by welding is so small that cracks are not readily produced. That is, particularly in the case of heat-welding, the use of substrates having a higher Tg than the vicinity of the welding temperature can markedly reduce the generation of cracks in the metallic circuit, improve the heat resistance and increase the current capacity. For the heat-resistant films which can satisfactorily be used as the substrate of the present invention, those having a Tg higher than 100°C are preferred.

Films useful as substrates in the invention include polyimide film, polyethylene terephthalate film, polysulfone film, polyether sulfone film, polyether ketone film, polyether imide film, polyester imide film, aromatic polyamide film, polyphenylene oxide film, polyxylylene film, polyamide imide film, etc. The thickness of the substrate is preferably $100\mu$ or less in order to maintain flexibility and to obtain stable connections.

For the electrically conductive particle used in the anisotropic electrically conductive adhesive layer, electrically conductive plastic particles may be used. Such particles are produced by covering the surface of spherical plastic particles with a film made of a good electrical conductor or semiconductor alone (e.g. gold, silver, copper, nickel, cobalt, palladium, chromium, aluminum, tungsten, manganese, indium, lead, tin) or an alloy consisting of these metals, or a laminated film made of these metals or alloys. The plastic particles may be made from various plastic materials including for example particles of phenolic, epoxy, polystyrene, polyvinyl chloride, polyethylene, polypropylene, polymethacrylic ester, polyacrylic ester, polyacrylonitrile and polymethacrylonitrile series resins. Of these resin particles, particles of phenolic, epoxy and polystyrene resins are particularly preferred. For the objects of the invention, the size of the plastic particles is preferably in a range of about 1 to $100\mu$ and most preferably from about 3 to $50\mu$, as expressed by an average particle diameter. The thickness of the covering metal is preferably in a range of from about 50 to 5000 $\mathring{A}$ in order to prevent circuit damage at the time of welding and to obtain sufficient electrical conductivity.

Specific examples of commercially available electrically conductive particles include: Bellpearl (nickel/phenolic resin particles; produced by Kanegafuchi Spinning Co., Ltd.), MPP (nickel + gold/crosslinked polystyrene resin particles; produced by Japan Synthetic Rubber, Co., Ltd.), Toraypearl EP-M (one or more of gold, silver, copper, tin, nickel and cobalt/epoxy resin particles; produced by Toray Industries Inc.), and Micropearl (nickel/crosslinked polystyrene resin particles; produced by Sekisui Fine Chemical Co.).

These metal-covered plastic particles do little damage to the circuit metals at the time of welding. In practical applications, the change of connection resistance under humid and heated conditions is more stable over time. This effect is more pronounced for a system wherein metals of poor corrosion resistance, for example a nickel/copper/nickel film, are used. Also, a small change in the shape of the plastic particles at the time of welding changes contact with the counter conductor from point contact to surface contact, which contributes to the stabilization of conduction.

Various insulating adhesives, such as pressure-sensitive, thermoplastic, thermosetting, photo-curing and electron ray-curing adhesives, etc., may be used in the anisotropic adhesive layer of the invention. Examples of useful adhesives include ethylene/vinyl acetate copolymer, ethylene/propylene copolymer, ethylene/acrylic acid copolymer, ethylene/acrylic esters copolymer, acrylic esters copolymer, styrene/butadiene copolymer, styrene/isoprene copolymer, polyisobutylene rubber, silicon rubber, polyvinyl butyral resin, acrylic acid resin, cyanoacrylate resin, epoxy resin, phenol resin, phenoxy resin, polyester, polyamide and polyurethane alone or in combination.

The content of the electrically conductive particles in the adhesive is preferably from 0.1 to 50% by volume based on the solids content of the adhesive. When the content is less than 0.1% by volume, stable conduction is difficult to obtain, and when the content exceeds 50% by volume, it is difficult to maintain insulation between the adjacent conductors.

The thickness of the anisotropic electrically conductive adhesive layer is dependent upon the diameter of the contained particles. It is preferably from about 0.5 to about 2 times the average particle diameter (when the particles form an aggregate, the average particle diameter means that of secondary particles).

The present invention will be illustrated in more detail with reference to the following examples, but it is not limited to these examples.

## Reference Examples 1 to 12

Metals as shown in Table 1 were each applied to several kinds of PET film and polyimide film of different thicknesses by vacuum evaporation (V) or sputtering (S), and the anchor force to the substrate, surface resistance of the thin metallic film, and corrosion resistance were measured under high-temperature and high-humidity conditions.

The anchor force was evaluated as follows: Insulating tap No. 56 (produced by Sumitomo Three M Co.) was adhered to a metal surface (by one forward/backward pass of a rubber roll of 2 kg in weight) and then peeled off the surface at $180°C$ to measure the area of the metal surface transferred from the substrate to the tape, and the anchor force was determined by the size of the area.

Symbols in Table 1 mean the followings:

Peeled-off area (area transferred to the tape No. 56)

- ●　0%
- O　1% or less
- △　1-10%
- ×　10% or more

The surface resistance of the metallic film was measured using a Loresta surface resistance meter (produced by Mitsubishi Petrochemical Co., Ltd.) and is expressed by the ratio of a value after a definite period of time to the initial value.

The corrosion resistance was evaluated as follows: Polyester resin R-251 (produced by Toray Industries Inc.) was applied in a thickness of from 10 to $20\mu$ to each metallic film and heat-welded to slide glass. The assembly was allowed to stand in a $60°C/95\%$ RH atmosphere and observed with the naked eye.

TABLE 1

| Reference Example | Structure of film and thin metallic film | Method of production | Anchor force | | Surface resistance ratio of thin metallic film After 1 week /initial stage | Corrosion resistance |
|---|---|---|---|---|---|---|
| | | | Initial stage | After 1 week | | |
| 1 | Silver 1000 Å/PET 25μ | V | Δ | × | 1 | Stable |
| 2 | Silver 1000 Å/PET 12μ (corona treatment) | V | . | × | 1.1 | Stable |
| 3 | Silver 1000 Å/PET 25μ | S | × | × | 0.85 | Stable |
| 4 | Gold 200 Å/PI 50μ | S | O | × | 0.90 | Stable |
| 5 | Gold 200 Å/PI 50μ | V | . | . | 0.92 | Stable |
| 6 | Palladium 500 Å/PI 50μ | S | O | Δ | 0.90 | Stable |
| 7 | Palladium 500 Å/PET 50μ | S | Δ | × | 0.96 | Stable |
| 8 | Copper 1000 Å/PET 25μ | V | . | O | 6.71 | Unstable |
| 9 | Aluminum 950 Å/PET 25μ | V | . | . | 2.18 | Unstable |
| 10 | Nickel 1000 Å/PET 25μ | V | . | O | 1.61 | Stable |
| 11 | Nickel 400 Å/copper 2000 Å/nickel 250 Å /PET 38μ | V | . | O | 1.69 | Stable |
| 12 | Nickel 400 Å/copper 2000Å/nickel 250 Å/PI 25μ | V | . | O | 1.03 | Stable |

EP 0 303 384 A2

The substrates with a circuit comprising a thin metallic film obtained in Reference examples are an intermediate product in the course of production of the present flexible connectors; thus whether a given substrate is suitable for the present flexible connectors cannot immediately be determined from Table 1. However, the data in Table 1 indicates that the substrates of Reference examples 11 and 12 having a circuit made of a laminated metallic thin film are particularly superior in the foregoing various characteristics.

## Examples 1, 3, 5, 7 and 9

Films with a thin metallic film composed as shown in Table 2 were prepared by evaporation on a polyimide film of 25μ in thickness, and etched using a resist to prepare a circuit pattern having conductors at an interval of 1 mm (width of conductor, 0.5 mm; gap , 0.5 mm).

Ten grams of a polyester resin R-251 (produced by Toray Industries Inc.) and 0.6 cm$^3$ of Micropearl 232 (average particle diameter 32μ; produced by Sekisui Fine Chemical Co.) were dissolved and dispersed, in 40 cc of 1,2-dichloroethane, coated in a thickness of 25μ onto the above films with a circuit pattern and dried at 110°C for 10 minutes (for Example 1, refer to the drawing). This assembly was heat-welded to ITO Glass (produced by Nippon Sheet Glass Co., Ltd.) at 120°C and 15 kgf/cm$^2$ pressure for 15 seconds (area of heat-welding portion, 10 mm x 2 mm). At that time, whether the particles pierced the metallic conductors was observed with the naked eye. Further, the flexible conductors thus obtained were allowed to stand under different environmental conditions, 40°C X 95% RH, 60°C X 95% RH and 80°C X 95% RH and measured for connection resistance (at 1 mA). These results are shown in Table 2.

## Examples 2, 4, 6, 8 and 10

The polyimide film of Examples 1, 3, 5, 7 and 9 was replaced by a polyethylene terephthalate (PET) film of the same thickness to prepare Examples 2, 4, 6, 8 and 10. The measurements were carried out in the same manner as in Examples 1, 3, 5, 7 and 9. These results are shown in Table 2.

## Comparative Examples 1 to 10

In examples 1 to 10, Micropearl 232 was replaced by nickel particles (average particle diameter, 32μ; produced by Sherritt Co., Ltd.), and the measurements were carried out in the same manner as in Examples 1 to 10. These results are shown in Table 2.

## Table 2

| | Structure of film and thin metallic film | Kind of particle |
|---|---|---|
| Example 1 | Nickel (0.04$\mu$)/copper(0.2$\mu$)/nickel(0.025$\mu$)/PI(25$\mu$) | Micropearl 232 |
| Comparative Example 1 | Nickel (0.04$\mu$)/copper(0.2$\mu$)/nickel(0.025$\mu$)/PI(25$\mu$) | Nickel particle |
| Example 2 | Nickel (0.04$\mu$)/copper(0.2$\mu$)/nickel(0.025$\mu$)/PET(25$\mu$) | Micropearl 232 |
| Comparative Example 2 | Nickel (0.04$\mu$)/copper(0.2$\mu$)/nickel(0.025$\mu$)/PET(25$\mu$) | Nickel particle |
| Example 3 | Silver (0.1$\mu$)/PI(25$\mu$) | Micropearl 232 |
| Comparative Example 3 | Silver (0.1$\mu$)/PI(25$\mu$) | Nickel particle |
| Example 4 | Silver (0.1$\mu$)/PET(25$\mu$) | Micropearl 232 |
| Comparative Example 4 | Silver (0.1$\mu$)/PET(25$\mu$) | Nickel particle |
| Example 5 | Copper (0.1$\mu$(/PI(25$\mu$) | Micropearl 232 |
| Comparative Example 5 | Copper (0.1$\mu$(/PI(25$\mu$) | Nickel particle |
| Example 6 | Copper (0.1$\mu$(/PET(25$\mu$) | Micropearl 232 |
| Comparative Example 6 | Copper (0.1$\mu$(/PET(25$\mu$) | Nickel particle |

EP 0 303 384 A2

EP 0 303 384 A2

<u>Table 2</u> (cont'd)

| | Structure of film and thin metallic film | Kind of particle |
|---|---|---|
| Example 7 | Nickel(7)-tin(3) alloy(0.04μ)/copper(0.2μ)/PI(25μ) | Micropearl 232 |
| Comparative Example 7 | Nickel(7)-tin(3) alloy(0.04μ)/copper(0.2μ)/PI(25μ) | Nickel particle |
| Example 8 | Nickel(7)-tin(3) alloy(0.04μ)/copper(0.2μ)/PET(25μ) | Micropearl 232 |
| Comparative Example 8 | Nickel(7)-tin(3) alloy(0.04μ)/copper(0.2μ)/PET(25μ) | Nickel particle |
| Example 9 | Nickel(7)-tin(3) alloy(0.04μ)/copper(0.2μ)/ nickel(7)-tin(3) alloy(0.03μ)/PI(25μ) | Micropearl 232 |
| Comparative Example 9 | Nickel(7)-tin(3) alloy(0.04μ)/copper(0.2μ)/ nickel(7)-tin(3) alloy(0.03μ)/PI(25μ) | Nickel particle |
| Example 10 | Nickel(7)-tin(3) alloy(0.04μ)/copper(0.2μ)/ nickel(7)-tin(3) alloy(0.03μ)/PET(25μ) | Micropearl 232 |
| Comparative Example 10 | Nickel(7)-tin(3) alloy(0.04μ)/copper(0.2μ)/ nickel(7)-tin(3) alloy(0.03μ)/PET(25μ) | Nickel particle |

Table 2 (cont'd)

| | Crack in welding portion | Connection resistance (Ω) | | | | | |
|---|---|---|---|---|---|---|---|
| | | 40°C X 95% RH | | 60°C X 95% RH | | 80°C X 95% RH | |
| | | Initial stage | After 250 hours | Initial stage | After 250 hours | Initial stage | After 250 hours |
| Example 1 | Not formed | 45 | 65 | 45 | 70 | 45 | 75 |
| Comparative Example 1 | Formed | | | | | | |
| Example 2 | Not formed | 45 | 65 | 45 | 75 | 45 | 80 |
| Comparative Example 2 | Formed | | | | | | |
| Example 3 | Not formed | 40 | 70 | 40 | 70 | 40 | 500 |
| Comparative Example 3 | Formed | | | | | | |
| Example 4 | Not formed | 40 | 70 | 40 | 70 | 40 | 600 |
| Compartive Example 4 | Formed | | | | | | |
| Example 5 | Not formed | 40 | 70 | 40 | >1000 | 40 | >1000 |
| Comparative Example 5 | Formed | | | | | | |
| Example 6 | Not formed | 40 | 75 | 40 | >1000 | 40 | >1000 |
| Comparative Example 6 | Formed | | | | | | |

EP 0 303 384 A2

Table 2 (cont'd)

| | Crack in welding portion | Connection resistance (Ω) | | | | | |
| --- | --- | --- | --- | --- | --- | --- | --- |
| | | 40°C X 95% RH | | 60°C X 95% RH | | 80°C X 95% RH | |
| | | Initial stage | After 250 hours | Initial stage | After 250 hours | Initial stage | After 250 hours |
| Example 7 | Not formed | | | 50 | 80 | 50 | 100 |
| Comparative Example 7 | Formed | | | | | | |
| Example 8 | Not formed | | | 50 | 80 | 50 | 110 |
| Comparative Example 8 | Formed | | | | | | |
| Example 9 | Not formed | | | 50 | 75 | 50 | 90 |
| Compartive Example 9 | Formed | | | | | | |
| Example 10 | Not formed | | | 50 | 75 | 50 | 95 |
| Comparative Example 10 | Formed | | | | | | |

It can be seen from Table 2 that neither the PET film nor the PI film can be used in combination with metallic particles independently of the kind of metal, but that they can be used in combination with the metal-covered plastic particle. Further, the connection resistance of the flexible connectors is low over a wide range of conditions in which nickel or its alloy is used in the topmost layer of the conductor.

## Examples 11 to 19

Three-layer thin metallic films were prepared on a polyimide film of 25μ in thickness by applying nickel, copper and nickel to the film in that order in the thickness of 250 Å, 2000 Å and 400 Å, respectively, by means of vacuum evaporation. The films were then etched using a resist to prepare a circuit pattern having conductors at an interval of 1 mm (width of conductor, 0.5 mm; gap, 0.5 mm).

Ten grams of a polyester resin R-251 (produced by Toray Industries Inc.) and 0.6 cm³ of electrically conductive plastic particles were dissolved and dispersed, respectively, in 40 cc of 1,2-dichloroethane, coated onto the above films with a circuit pattern and dried at 110°C for 10 minutes. This assembly was heat-welded to ITO Glass (produced by Nippon Sheet Glass Co., Ltd.) at 150°C and 15 kgf/cm² for 15 seconds. Thereafter, the change in connection resistance with the lapse of time was measured under a condition of 60°C X 95% RH. The results are shown in Table 3.

## Example 20

A flexible connector was prepared in the same manner as in Example 11 except that the evaporation film conductor (circuit) was of a two-layer structure of copper and nickel applied to the film in that order in the thickness of 200 Å and 400 Å, respectively, and that 0.6 cm³ of Micropearl 232 (produced by Sekisui Fine chemical Co.) was used as the electrically conductive plastic particles, and the properties were measured similarly. The results are shown in Table 3.

## Example 21

A flexible connector was prepared in the same manner as in Example 20 except that the circuit was of a single-layer structure of nickel of 1000 Å in thickness, and the properties were measured similarly. The results are shown in Table 3.

## Example 22

A flexible connector was prepared in the same manner as in Example 20 except that the circuit was of a two-layer structure of nickel and copper applied to the film in this order in the thickness of 250 Å and 2000 Å, respectively, and the properties were measured similarly. The results are shown in Table 3.

## Example 23

A flexible connector was prepared in the same manner as in Example 20 except that the circuit was of a single-layer structure of copper of 1000 Å in thickness, and the properties were measured similarly. The results are shown in Table 3.

## Example 24

A flexible connector was prepared in the same manner as in Example 20 except that the circuit was of a two-layer structure of copper and a nickel(7)-tin(3) alloy applied to the film in this order in the thickness of 2000 Å and 400 Å, respectively, and the properties were measured similarly. The results are shown in Table 3.

## Example 25

A flexible connector was prepared in the same manner as in Example 20 except that the circuit was of a three-layer structure of a nickel(7)-tin(3) alloy, copper and a nickel(7)-tin(3) alloy which were applied to the film in this order in the thickness of 250 Å, 2000 Å and 400 Å, respectively. The properties were measured similarly. The results are shown in Table 3.

Table 3

| Example | Structure of film and thin metallic film | Kind of particle | Average particle diameter ($\mu$) | Adhesive Thickness (X average particle diameter) | Connection resistance ($\Omega$) | |
|---|---|---|---|---|---|---|
| | | | | | Initial Stage | After 250 hours |
| 11 | Ni/Cu/Ni/PI | Bellpearl N-800 | 18 | 0.75 | 35 | 35 |
| 12 | Ni/Cu/Ni/PI | Bellpearl N-800 | 18 | 1 | 35 | 50 |
| 13 | Ni/Cu/Ni/PI | Bellpearl N-800 | 18 | 1.25 | 35 | 50 |
| 14 | Ni/Cu/Ni/PI | Toraypearl EP-M | 8 | 2 | 75 | 80 |
| 15 | Ni/Cu/Ni/PI | Micropearl NI-215 | 15 | 1 | 30 | 35 |
| 16 | Ni/Cu/Ni/PI | Micropearl NI-232 | 32 | 0.75 | 35 | 35 |
| 17 | Ni/Cu/Ni/PI | Micropearl NI-232 | 32 | 1 | 35 | 35 |
| 18 | Ni/Cu/Ni/PI | Micropearl NI-232 | 32 | 1.25 | 40 | 60 |
| 19 | Ni/Cu/Ni/PI | JSR MPP | 10 | 1 | 30 | 30 |
| 20 | Ni/Cu/PI | Micropearl NI-232 | 32 | 1 | 30 | 45 |
| 21 | Ni/PI | Micropearl NI-232 | 32 | 1 | 60 | 65 |
| 22 | Cu/Ni/PI | Micropearl NI-232 | 32 | 1 | 25 | >1000 |
| 23 | Cu/PI | Micropearl NI-232 | 32 | 1 | 25 | >1000 |
| 24 | Ni-Sn/Cu/PI | Micropearl NI-232 | 32 | 1 | 45 | 60 |
| 25 | Ni-Sn/Cu/Ni-Sn/PI | Micropearl NI-232 | 32 | 1 | 45 | 60 |

The data indicate that with connectors according to the present invention, cracks do not form in the circuit at the time of application. The data further indicate that the present invention provides connectors that can maintain stable and low connection resistance over a long period of time even under humid and heated circumstances, that have excellent conduction characteristics and that are rich in flexibility.

## Claims

1. A flexible connector comprising a circuit consisting of a thin metallic film on a substrate and an anisotropic electrically conductive adhesive layer on said circuit, wherein said electrically conductive adhesive contains plastic particles having at least one metallic coating on the surface thereof.

2. A flexible connector according to Claim 1, wherein said thin metallic film is a laminated metallic film having nickel or an alloy containing at least 50% by weight of nickel in the topmost layer contacting with said electrically conductive adhesive.

3. A flexible connector according to Claim 1, wherein said thin metallic film is a laminated metallic film having nickel or an alloy containing at least 50% by weight of nickel in the lowermost layer contacting with said substrate.

4. A flexible connector according to Claim 1, wherein said thin metallic film is a laminated metallic film having copper or an alloy containing at least 50% by weight of copper in an intermediate layer.

5. A flexible connector according to Claim 1, wherein said plastic particles comprise phenolic, epoxy or polystyrene series plastics.

6. A flexible connector according to Claims 1, wherein said adhesive is selected from the group consisting of pressure-sensitive, thermoplastic, thermosetting, photo-curing and electron ray-curing adhesives.

7. A flexible connector according to Claim 1 wherein said adhesive is selected from the group consisting of ethylene/vinyl acetate copolymer, ethylene/propylene copolymer, ethylene/acrylic acid copolymer, ethylene/acrylic esters copolymer, acrylic esters polymers, styrene/butadiene copolymer, styrene/isoprene copolymer, polyisobutylene rubber, silicon rubber, polyvinyl butyral resin, acrylic acid resin, cyancacrylate resin, epoxy resin, phenol resin, phenoxy resin, polyester, polyamides, polyurethanes or any combination thereof.

8. A flexible connector according to Claim 1 wherein said plastic particles are present in a range from 0.1% to 50% by volume based on the solid content of the adhesive.

9. A flexible connector according to Claim 1 wherein said thin metallic film is a three-layer laminated metallic film comprised on a first layer of nickel or an alloy containing at least 50% by weight of nickel contacting said substrate, a second layer of copper or an alloy containing at least 50% by weight of copper, and a third layer of nickel or an alloy containing at least 50% by weight of nickel contacting said adhesive.

10. A flexible connector according to Claim 1 wherein said adhesive layer thickness if from about 0.5 to 2 times the average diameter of said plastic particles.